# EUROPEAN PATENT SPECIFICATION

(11) **EP 4 070 383 B1**
(45) Date of publication and mention of the grant of the patent: **24.01.2024**
(21) Application number: 19817246.2
(22) Date of filing: 05.12.2019
(51) Int. Cl.: H10N 69/00, H10N 60/10, H10N 60/01, G06N 10/40

(54) **SEMICONDUCTOR-FERROMAGNETIC INSULATOR-SUPERCONDUCTOR HYBRID DEVICES**
HALBLEITER-FERROMAGNETISCHER ISOLATOR-SUPRALEITER-HYBRIDVORRICHTUNGEN
DISPOSITIFS HYBRIDES ISOLANT-SUPRACONDUCTEUR SEMI-CONDUCTEUR-FERROMAGNÉTIQUE

(43) Date of publication of application: 12.10.2022
(73) Proprietor: Microsoft Technology Licensing LLC, Redmond, WA 98052-6399 (US)
(72) Inventor: VAITIEKENAS, Saulius, Redmond, Washington 98052-6399 (US); MARCUS, Charles Masamed, Redmond, Washington 98052-6399 (US); Krogstrup Jeppesen, Peter, Redmond, Washington 98052-6399 (US)
(74) Representative: Page White Farrer
(86) International application number: PCT/EP2019/083904
(87) International publication number: WO 2021/110274

(56) References cited:
- US-A1- 2020 227 636
- JACOB LINDER ET AL: "Majorana fermions manifested as interface-states in semiconductor hybrid structures", ARXIV.ORG, CORNELL UNIVERSITY LIBRARY, 201 OLIN LIBRARY CORNELL UNIVERSITY ITHACA, NY 14853, 21 April 2010 (2010-04-21), XP080447014, DOI: 10.1103/PHYSREVB.82.085314
- JASON ALICEA: "Majorana fermions in a tunable semiconductor device", ARXIV.ORG, CORNELL UNIVERSITY LIBRARY, 201 OLIN LIBRARY CORNELL UNIVERSITY ITHACA, NY 14853, 10 December 2009 (2009-12-10), XP080381815, DOI: 10.1103/PHYSREVB.81.125318
- LONG-HUA WU ET AL: "Chiral Majorana fermion edge states in a heterostructure of superconductor and semiconductor with spin-orbit coupling", JOURNAL OF PHYSICS: CONFERENCE SERIES, INSTITUTE OF PHYSICS PUBLISHING, BRISTOL, GB, vol. 393, no. 1, 26 November 2012 (2012-11-26), page 12018, XP020232818, ISSN: 1742-6596, DOI: 10.1088/1742-6596/393/1/012018
- EYTAN GROSFELD ET AL: "Observing Majorana bound states of Josephson vortices in topological superconductors", ARXIV.ORG, CORNELL UNIVERSITY LIBRARY, 201 OLIN LIBRARY CORNELL UNIVERSITY ITHACA, NY 14853, 11 December 2010 (2010-12-11), XP080467845, DOI: 10.1073/PNAS.1101469108

## Description

### Background

Topological quantum computing is based on the phenomenon whereby non-abelian anyons, in the form of "Majorana zero modes" (MZMs), can be formed in regions where a semiconductor is coupled to a superconductor. A non-abelian anyon is a type of quasiparticle, meaning not a particle per se, but an excitation in an electron liquid that behaves at least partially like a particle. An MZM is a particular bound state of such quasiparticles. Under certain conditions, these states can be formed close to the semiconductor-superconductor interface in a nanowire formed from a length of semiconductor coated with a superconductor. When MZMs are induced in the nanowire, it is said to be in the "topological regime". To induce this requires a magnetic field, conventionally applied externally, and also cooling of the nanowire to, or below, a temperature that induces superconducting behaviour in the superconductor material. It may also involve gating a part of the nanowire with an electrostatic potential.

By forming a network of such nanowires and inducing the topological regime in parts of the network, it is possible to create a quantum bit (qubit) which can be manipulated for the purpose of quantum computing. A quantum bit, or qubit, is an element upon which a measurement with two possible outcomes can be performed, but which at any given time (when not being measured) can in fact be in a quantum superposition of the two states corresponding to the different outcomes.

To induce MZMs, the device is cooled to a temperature where the superconductor (e.g. aluminium, Al) exhibits superconducting behaviour. The superconductor causes a proximity effect in the adjacent semiconductor, whereby a region of the semiconductor near the interface with the superconductor also exhibits superconducting properties. Topological phase behaviour is induced in the adjacent semiconductor as well as the superconductor. It is in this region of the semiconductor where the MZMs are formed.

Another condition for inducing the topological phase where MZMs can form is the application of a magnetic field in order to lift the spin degeneracy in the semiconductor. Degeneracy in the context of a quantum system refers to the case where different quantum states have the same energy level. Lifting the degeneracy means causing such states to adopt different energy levels. Spin degeneracy refers to the case where different spin states have the same energy level. Spin degeneracy can be lifted by means of a magnetic field, causing an energy level spilt between the differently spin-polarized electrons. This is known as the Zeeman effect. The g-factor refers to the coefficient between the applied magnetic field and the spin splitting. Typically, the magnetic field is applied by an external electromagnet.

An alternative route to creating topological materials and superconducting memory elements that does not require external magnetic (Zeeman) field involves combinations of semiconducting, superconducting, and ferromagnetic insulator materials hybridized into a single device. These systems have been proposed theoretically [Sau, et al., PRL 104, 040502 (2010)].

US patent application 16/246287 (published as US 2020/0227636 A1) has also disclosed a heterostructure in which a layer of a ferromagnetic insulator is disposed between the superconductor and semiconductor in order to internally apply the magnetic field for lifting the spin degeneracy, without the need for an external magnet. US 16/246287 indicates that an exchange field between the ferromagnetic insulator and the semiconductor causes a split in energy levels. Examples given for the ferromagnetic insulator included compounds of heavy elements in the form of EuS, EuO, GdN, Y₃Fe₅O₁₂, Bi₃Fe₅O₁₂, YFeO₃, Fe₂O₃, Fe₃O₄, Sr₂CrReO₆, CrBr₃/Crl₃, YTiO₃ (the heavy elements being Europium, Gadolinium, Yttrium, Iron, Strontium and Rhenium).

The fabrication of nanowire heterostructures comprising InAs and Al layers has been reported [Krogstrup, et al., Nat. Mater. 14, 400 (2015)].

Linder and Sudbø (arXiv:1007.3786v1 [cond-mat.mes-hall]) discloses possible experimental fingerprints of Majorana fermions in semiconductor hybrid structures.

Alicea (arXiv:0912.2115v1 [cond-mat.str-el) discloses a device in which a topological superconducting phase is driven by applying an in-plane magnetic field to a (110)-grown semiconductor coupled only to an s-wave superconductor.

Wu et al (Journal of Physics: Conference Series 393 (2012) 012018) discloses a study of low-energy excitations in a device consisting of a spin-orbit coupling semiconductor, an s-wave superconductor and a ferromagnetic insulator.

Grosfeld and Stern (arXiv:1012.2492v2 [cond-mat.supr-con]) discloses a study of equations governing dynamics of phase solitons in a Josephson junction in a topological superconductor.

### Summary

Provided herein are devices comprising a combination of semiconductor, superconductor, and ferromagnetic insulator components.

Experiments provide strong evidence that such hybrid devices allow access to topological modes at zero external magnetic fields. This would greatly ease the requirements for topological qubits. For instance, the structures would not need to be aligned with a single direction-the direction of the applied magnetic field-and would not need to be sized to fit into the bore of a high-field magnet, typically a few inches in diameter. Also, in many instances, other proximal devices or structures may be harmed by or changed by magnetic fields. For memory devices, the devices offer the possibility of storage of information in the ferromagnetic insulator that affects supercurrent through the device. Memory devices are of critical importance in the use of superconducting electronics for fast computation.

In one aspect, the present invention provides a semiconductor-ferromagnetic insulator-superconductor hybrid device according to claim 1. The device comprises a semiconductor component, a ferromagnetic insulator component, and a superconductor component. The semiconductor component has at least three facets. The ferromagnetic insulator component is arranged on a first facet and a second facet. The superconductor component is arranged on a third facet and extends over the ferromagnetic insulator component on at least the second facet.

Related aspects of the invention provide a network of at least two semiconductor-ferromagnetic insulator-superconductor hybrid devices according to claim 9; and a quantum computer device comprising the semiconductor-ferromagnetic insulator-superconductor hybrid device or the network, according to claim 10.

In another aspect, the present invention provides a method of fabricating a semiconductor-ferromagnetic insulator-superconductor hybrid device, according to claim 11. The method comprises: providing a semiconductor component having at least three facets; directionally depositing, from a first direction, a ferromagnetic insulator component selectively on a first facet and a second facet of the semiconductor component; and forming a superconductor component on at least a third facet of the semiconductor component and over the ferromagnetic insulator component on the second facet.

In another aspect, the present invention provides a method of inducing topological behaviour in a semiconductor-ferromagnetic insulator-superconductor hybrid device, according to claim 14. The method comprises: cooling the semiconductor-ferromagnetic insulator-superconductor hybrid device to a temperature at which the superconductor component is superconductive and the ferromagnetic insulator component is below a Curie temperature of the ferromagnetic insulator component; and applying an electrostatic field to the semiconductor-superconductor hybrid device.

Certain more specific aspects of the invention are set out in the dependent claims.

### Brief Description of the Drawings

To assist understanding of embodiments of the present disclosure and to show how such embodiments may be put into effect, reference is made, by way of example only, to the accompanying drawings in which:
Fig. 1 shows cross-sections of 6 different semiconductor-ferromagnetic insulator-superconductor hybrid device structures (A) to (F);
Fig. 2 shows a cross-section of an example semiconductor-ferromagnetic insulator-superconductor hybrid device based on a selective-area-grown nanowire;
Fig. 3 shows a plan view of an example network of nanowires incorporating two semiconductor-ferromagnetic insulator-superconductor hybrid devices;
Fig. 4 is a flow chart of an example method of fabricating a semiconductor-ferromagnetic insulator-superconductor hybrid device; and
Fig. 5 is a flow chart of an example method of inducing topological behaviour in a semiconductor-ferromagnetic insulator-superconductor hybrid device.

The Figs. are schematic, and are not to scale. The relative proportions of components shown may be exaggerated for ease of representation.

### Detailed Description of Embodiments

As used herein, the verb 'to comprise' is used as shorthand for 'to include or to consist of'. In other words, although the verb 'to comprise' is intended to be an open term, the replacement of this term with the closed term 'to consist of' is explicitly contemplated, particularly where used in connection with chemical compositions.

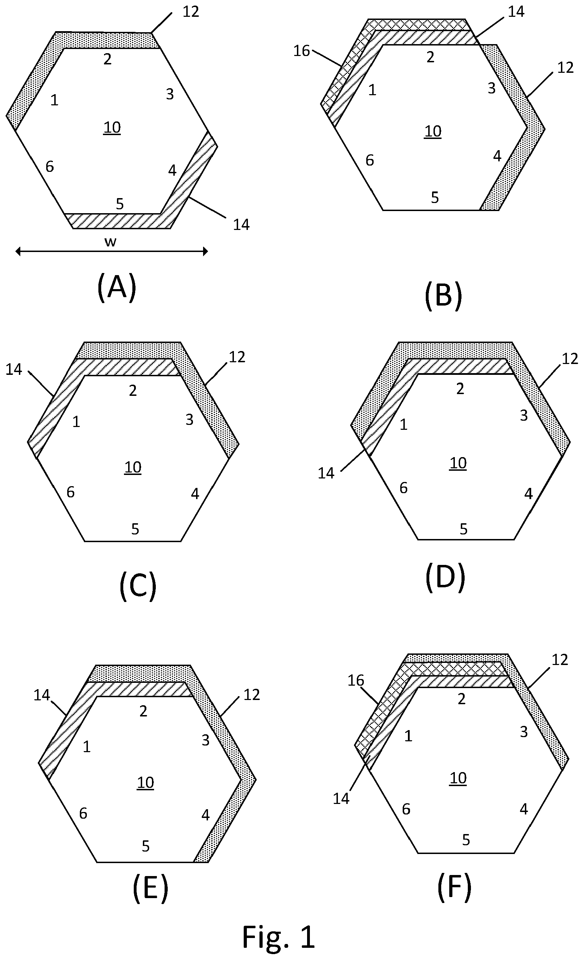

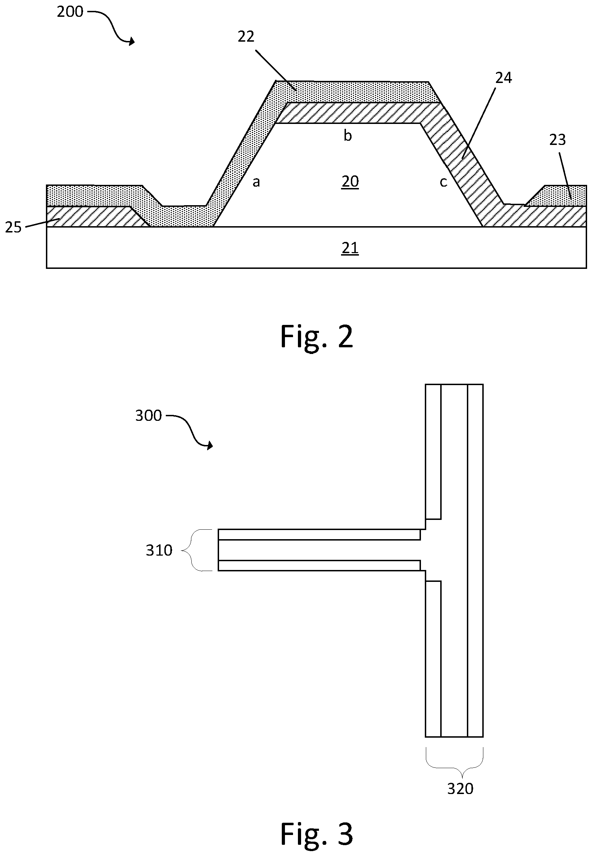

Directional terms such as "top", "bottom", "left", "right", "above", "below", "horizontal" and "vertical" are used herein for convenience of description and relate to the device when viewed in the orientation illustrated in Figs. 1 and 2. For the avoidance of any doubt, this terminology is not intended to limit the orientation of the device in an external frame of reference.

Unless context clearly dictates otherwise, a component is "on" another component when the components are in direct contact.

As used herein, the term "superconductor" refers to a material which becomes superconductive when cooled to a temperature below a critical temperature, T_{c}, of the material. Likewise, a "ferromagnetic insulator" is a material which is ferromagnetic when cooled to a temperature below the Curie temperature of the material. The use of these terms is not intended to limit the temperature of the device.

A "nanowire" as referred to herein is an elongate member having a nano-scale width, and a length-to-width ratio of at least 100, or at least 500, or at least 1000. A typical example of a nanowire has a width in the range 10 to 500 nm, optionally 50 to 100 nm or 75 to 125 nm. Lengths are typically of the order of micrometers, e.g. at least 1 µm, or at least 10 µm. In the present context, the nanowires are typically formed of a semiconductor material.

Provided herein are semiconductor-ferromagnetic insulator-superconductor hybrid devices. It has been found that improvements in operating parameters may be achieved by varying the topology of the device.

Five different semiconductor-ferromagnetic insulator-superconductor hybrid devices A to E were fabricated. Properties of the devices were investigated using low-temperature tunnelling spectroscopy. Schematic cross-sections of these devices investigated are shown in Fig. 1. Fig. 1 further shows an additional device structure, F.

The semiconductor-ferromagnetic insulator-superconductor hybrid devices A to F each comprise a semiconductor component 10. The semiconductor component 10 comprises indium arsenide. The semiconductor component 10 is the form of a nanowire. The nanowire has a diameter w in the range 50 to 150 nm, the diameter w being the maximum width of the semiconductor in cross section. In other words, diameter w is the diameter of the smallest circle that will surround fully the cross-section of the nanowire.

In the examples illustrated in Fig. 1, the semiconductor components 10 have a hexagonal cross-section, with six facets. Facets have been labelled 1 to 6 sequentially, clockwise. As will be appreciated, it is the relative positions of components which are relevant, rather than the facet numbering given in the drawings.

In examples where the semiconductor component is configured as a nanowire, the relevant facets are side facets. End facets are not considered in the following discussion. Surface area at the ends of a nanowire is very small compared to the area of surfaces along the length of the nanowire. Fig. 1 illustrates cross-sections of vapour-liquid-solid, VLS, grown nanowires which have six side facets because of the crystallographic direction along which the wires were grown.

The Fig. 1 devices further include superconductor components 12. In the present examples, the superconductor components 12 comprise aluminium. The aluminium is in the form of a layer having a thickness in the range 3 to 10 nm. The size of aluminium's superconductive gap may vary with layer thickness. Generally, the smaller the thickness, the larger the superconductive gap. This has been previously observed for example in Court, et al. Supercond. Sci. Technol. 21, 015013 (2008). It is desirable to maximise the superconductive gap of the superconductor component 12 because this may increase the topological gap of the device.

A natural oxide layer (not illustrated) may form on the surface of aluminium. The natural oxide layer typically has a thickness of about 2 nm.

In Fig. 1, superconductor components 12 are depicted as single layers. In variants, a superconductor component may comprise two or more layers of different materials which together display superconductive behaviour at an operating temperature of the device.

For example, a superconductor component may comprise a layer of a first superconductor material arranged on the semiconductor component; and a layer of a second superconductor material arranged on the layer of the first superconductor material. The second superconductor material may have a larger superconductor gap than the first superconductor material. The first superconductor material may be selected to form a beneficial interface with the semiconductor component.

The Fig. 1 devices further include a ferromagnetic insulator component 14. In these examples, the ferromagnetic insulator component 14 comprises europium sulfide. The europium sulfide is in the form of a layer having a thickness of at least 1 nm, and generally in the range 2 to 10 nm.

Ferromagnetic insulator materials generate an exchange field, which may act as an effective external magnetic (Zeeman) field when their temperature is less than a certain threshold, referred to as the Curie temperature. The Curie temperature of a ferromagnetic insulator component may vary depending on the thickness of the component. Generally, as thickness decreases, Curie temperature decreases. For example, a europium sulfide layer having a thickness of about 5 nm may have a Curie temperature of approximately 16 to 17 K. In practice, however, the Curie temperature of the ferromagnetic insulator is not a limiting factor. Usually, the critical temperature T_{c} of the superconductor component is of the order of about 1 K, regardless of the material selected. This is already well below the Curie temperature.

Devices B and F further comprise protective insulator layers 16. In these examples, the protective insulator layer 16 is a layer of aluminium oxide. The aluminium oxide may have a thickness of 2 to 10 nm. In a variant, protective insulator layer 16 may comprise an alternative oxide such as silicon oxide.

The Fig. 1 devices and their properties will now be discussed in turn.

In device A, superconductor component 12 is arranged on first and second facets 1, 2 of the semiconductor component 10. The ferromagnetic insulator component 14 is arranged on fourth and fifth facets 4, 5 which are opposite the first and second facets 1,2 respectively. No components were arranged on the third facet 3 or the sixth facet 6 of the semiconductor component 10.

Device A did not display any signs of ferromagnetism when examined using low-temperature tunnelling spectroscopy. Without wishing to be bound by theory, it is believed that electrons are localised at the InAs/AI interface, remote from the ferromagnetic insulator component. It is believed that the ferromagnetism is not proximitized throughout the whole cross section of the nanowire. The signature of MZMs, i.e. the computationally-relevant excitations, were not observed in device A.

Device B has the ferromagnetic insulator component 14 arranged on first and second facets 1, 2 of the semiconductor component 10. Superconductor component 12 is arranged on third and fourth facets 3, 4 of the semiconductor component 10, the third facet 3 being adjacent to the second facet 2. No components are arranged on the fifth and sixth facets 5 and 6.

Device B further includes protective insulator component 16, arranged on the ferromagnetic insulator component 14. In this example, the protective insulator component 16 serves as a barrier, protecting the ferromagnetic insulator component 14. Protective insulator component 16 may, for example, protect the ferromagnetic insulator component 14 during fabrication of the device. In the finished device, protective insulator component 16 may protect the ferromagnetic insulator component 14 from the effects of atmospheric oxygen or water vapour.

Investigation of Device B using low-temperature tunnelling spectroscopy uncovered evidence of the effects of ferromagnetism on the semiconductor-superconductor interface. A split density of states was observed. Hysteresis in the evolution of density of states in response to a B-field (an external magnetic field) was also observed. However, there was no clear evidence of relevant bound states such as Majorana zero modes.

In device C, the ferromagnetic insulator component 14 is arranged on first and second facets 1, 2 of the semiconductor component 10. The superconductor component 12 is arranged on the third facet 3 of the semiconductor component. The superconductor component 12 also extends over the part of the ferromagnetic insulator component on second facet 2. Superconductor component 12 does not however extend over the part of the ferromagnetic insulator component on the first facet 1.

Put differently, first facet 1 is provided with a layer of ferromagnetic insulator; second facet 2 is provided with a layer of ferromagnetic insulator covered by a layer of superconductor; and third facet 3 is provided with a layer of superconductor.

No components are arranged over the fourth, fifth or sixth facets 4, 5, 6 of device C's semiconductor component 10.

Device C showed signs of ferromagnetism, such as hysteresis; a reduced superconducting gap in comparison with a reference device lacking the ferromagnetic insulator component; and subgap states including zero-bias peaks, ZBPs. The reduction in superconducting gap and the presence of ZBPs are the main signatures of a topological phase. In other words, there were clear signs that device C generates Majorana zero modes.

Device D of Fig. 1 is similar to device C, differing only in that the superconductor component 12 further extends over the ferromagnetic insulator component 14 on the first facet.

In other words, in device D, first facet 1 and second facet 2 are both provided with a layer of ferromagnetic insulator covered by a layer of superconductor; and third facet 3 is provided with a layer of superconductor.

Device D showed a reduced superconducting gap, similar to Device C. Device D also showed hysteresis in B-field density of states. However, effects were weaker compared to device C. The evidence of generation of Majorana zero modes was weaker that for Device C, but it is believed that Device D is nevertheless useful for quantum computing applications.

Considering now device E, this device is similar to device D, differing in that the superconductor component further extends over a fourth facet 4 of the semiconductor component 10.

In device E, first facet 1 and second facet 2 are both provided with a layer of ferromagnetic insulator covered by a layer of superconductor; third facet 3 is provided with a layer of superconductor; and fourth facet 4 is provided with a layer of superconductor.

Device E did not show the useful behaviours observed for devices C and D. Only a small reduction in superconducting gap was observed in device E. Without wishing to be bound by theory, it is believed that electrons in device E are predominantly located at the right middle corner (i.e., the corner between facets 3 and 4 as illustrated in Fig. 1) of the InAs semiconductor interfacing only with Al and the interaction with the ferromagnetic insulator shell was too weak.

Device F is a variant of device C, differing from device C by including an insulating component 16 arranged over the ferromagnetic insulator component 14. In the region of the second facet 2 of the semiconductor component 10, insulating component 16 lies between the ferromagnetic insulator 14 and the superconductor component 12.

Device F is expected to behave in a similar way to device C. Further, capping the ferromagnetic insulator component 14 with a protective insulating component 16 may be useful during manufacture of the device. Fabrication of the device may include wet etching of a superconductor shell to form the superconductor component 12. Protective insulating component 16 may prevent the etchant from contacting the ferromagnetic insulator component. This may allow for a wider variety of etchants to be used.

In examples where the ferromagnetic insulator component 14 comprises EuS, the protective insulating component may prevent EuS from oxidizing to EuO. Although EuO is useful as a ferromagnetic insulator component, EuS has different magnetic properties and may be preferred for some applications. Encapsulation of a component by the protective insulating component generally provides protection of the surfaces of the overall system from exposure to air, and particularly the detrimental effects of oxygen in air.

Thus, it may be seen that by providing a ferromagnetic insulator component arranged on a first facet and a second facet and a superconductor component arranged on a third facet and extends over the ferromagnetic insulator component on the second facet, and optionally also over the ferromagnetic insulator component on the first facet, Majorana zero modes may be generated in the device. The strongest effects are observed when the superconductor component does not extend over the ferromagnetic insulator on the first facet, although configurations where the superconductor component does extend over the ferromagnetic insulator on the first facet are still useful.

Although the above examples refer to the use of a hexagonal nanowire, and to particular materials, the underlying concepts may be extended to other materials and other device topologies.

For example, Fig. 2 illustrates an alternative device topology based on the observations described above.

The semiconductor-ferromagnetic insulator-superconductor hybrid device 200 of Fig. 2 comprises a semiconductor component 20, a superconductor component 22 and a ferromagnetic insulator 24.

Semiconductor component 20 is in the form of a nanowire. In the present example, the semiconductor component 20 extends from a surface of a substrate 21. Semiconductor component 20 is generally trapezoidal in cross-section, and has three facets a, b and c. Nanowires having this configuration may be fabricated using selective area growth, SAG. During fabrication, growth time for the nanowire is selected such that a nanowire having three side facets is obtained. If growth is allowed to continue for too long, then a nanowire having a triangular cross-section, in which sides a and c have grown together thereby eliminating side b, is obtained.

The substrate 21 provides a base on which the semiconductor component 20 is grown. The substrate material is not particularly limited, and may be selected as appropriate. Substrate 21 may be a semiconductor wafer, for example. Indium phosphide is one illustrative example of a substrate material.

The arrangement of superconductor component 22 and ferromagnetic insulator component 24 is analogous to that shown in device C of Fig. 1.

The ferromagnetic insulator component 24 is arranged on two facets b,c of the semiconductor component 20. As shown in Fig. 2, facet b is a top facet, and facet c is a first side facet.

Ferromagnetic insulator component 24 also extends over part of the substrate 21, on the right-hand side of the semiconductor component as illustrated. The region of ferromagnetic insulator on the substrate is not essential for operation of the device, and may be omitted.

The superconductor component 22 is arranged on a second side facet a. Superconductor component 22 also extends over the part of ferromagnetic insulator component 24 which covers the top facet b, but not the part of the ferromagnetic insulator component 24 which covers first side facet c.

Superconductor component 22 further extends over part of the substrate 21 on the left-hand side of the semiconductor component 10 as illustrated. This portion of superconductor is not essential for operation of the device, and may be omitted.

Semiconductor-ferromagnetic insulator-superconductor hybrid device 200 as illustrated in Fig. 2 further includes an additional portion of superconductor component 23, arranged on the ferromagnetic insulator to the right-hand side of the device as illustrated. An additional portion of ferromagnetic insulator 25 is present on the substrate 21 to the left hand-side of the device as illustrated. Additional portions 23, 25 may be present when the superconductor component 22 and ferromagnetic insulator component 24 are fabricated using direction deposition processes. Such portions have no particular impact on the operation of the device, and their presence is tolerated. These portions might not be present if alternative fabrication processes are used.

In a variant, additional portion of superconductor material 23 may usefully form part of a gate electrode for applying an electrostatic field to the device.

Semiconductor-ferromagnetic insulator-superconductor hybrid devices as disclosed herein may be useful for constructing memory devices for quantum computing applications. Such devices may comprise a network of nanowires, the nanowires being configured as semiconductor-superconductor hybrid devices as provided herein. In this context, the memory function would operate in the superconducting regime, allowing much faster operation than conventional semiconductor-based electronics.

Fig. 3 illustrates an example network 300 comprising two nanowires 310, 320. Each nanowire 310, 320 may be configured as a device of the type described with reference to Fig. 2, for example. In this device, there is a junction between two nanowires. This may allow Majorana zero modes to be moved past one another. This is useful because moving Majorana quasiparticles relative to one another produces interesting phenomena which may allow encoding of information. For example, non-abelian braiding statistics may be observed.

Generating Majorana zero modes may require a magnetic field to be oriented in a particular direction with respect to the superconductor and semiconductor components, i.e., relative to the direction of the nanowire. Since the semiconductor-superconductor hybrid devices provided herein include ferromagnetic insulator components, device design is no longer restricted by a need to apply a magnetic field externally.

Although the Fig. 3 example shows a relatively simple 'T'-shaped junction, other more complex nanowire networks may be constructed. For example, a variant comprises four nanowires arranged in a loop.

Nanowire networks and their fabrication are described by Vaitiekénas et al (Phys. Rev. Lett. 121, 147701 (2018); arXiv:1802.04210v3 [cond-mat.mes-hall]) and Krizek et al (Phys. Rev. Materials 2, 093401 (2018); also available at arXiv:1802.07808v2 [cond-mat.mtrl-sci]).

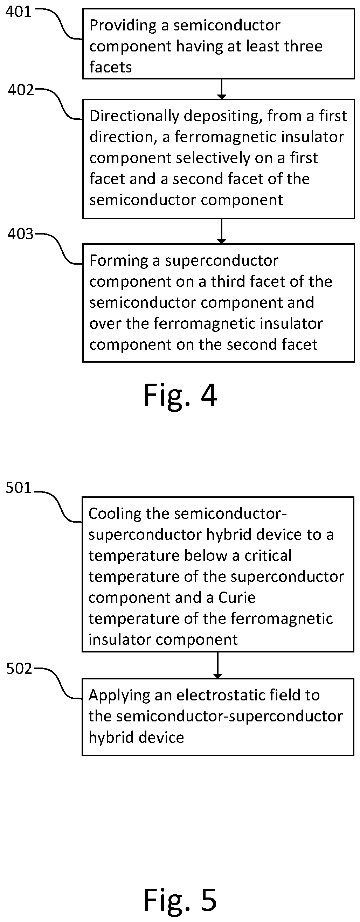

A method of fabricating a semiconductor-ferromagnetic insulator-superconductor hybrid device will now be described with reference to Fig. 4.

At block 401, a semiconductor component having at least three facets is provided.

For example, a semiconductor component in the form of a nanowire may be grown by molecular beam epitaxy. This may produce a nanowire having a hexagonal cross-section, with 6 facets.

The vapour-liquid-solid, VLS, technique is one more specific example of a molecular beam epitaxy process. Semiconductor components of devices A to E were fabricated using this technique.

If desired, a semiconductor component produced by VLS may be placed on a substrate, or some other support, before performing the remaining steps of the present method.

Selective area growth, SAG, is another technique useful for fabricating semiconductor nanowires. Briefly, an SAG process comprises forming a patterned mask on a crystalline substrate, and growing a crystal of a material (in this example, a semiconductor material) epitaxially on the substrate in regions left exposed by the patterned mask. SAG may be used to construct devices of the type described with reference to Fig. 2, for example. SAG produces a semiconductor component which is formed integrally to the substrate.

At block 402, a ferromagnetic insulator component is selectively deposited on a first facet and a second facet of the semiconductor component, using directional deposition from a first direction.

Molecular beam epitaxy is one example of a technique for directional deposition.

Directional deposition allows the ferromagnetic insulator component to be grown on selected facets of the semiconductor component. The semiconductor component may be "self-shadowing": in such examples, the shape of the semiconductor component itself may block growth of ferromagnetic insulator component at locations where such growth is not desired. This may be achieved by selecting an appropriate beam angle.

After depositing the ferromagnetic insulator component, an additional insulator component for protecting the ferromagnetic insulator component may be formed on the ferromagnetic insulator component. This step may comprise forming an aluminium oxide layer on the ferromagnetic insulator component, for example.

At block 403, a superconductor component is formed on a third facet of the semiconductor component and over the ferromagnetic insulator component on the second facet.

This step may, for example, comprise depositing the superconductor component using directional deposition from a second direction, different from the first direction used at block 402.

As in block 402, the semiconductor component may be self-shadowing.

Alternative examples make use of a mask or stencil to control deposition of the superconductor component.

A still further possibility is to deposit superconductor material non-directionally, and then selectively remove portions of the superconductor material in areas where superconductor material is not desired. The use of a protective insulating layer over the ferromagnetic insulating component may be preferred in such cases.

The method may include additional steps, such as forming a gate electrode for applying an electrostatic field to the device. This could be performed at any stage of the process as appropriate depending on the configuration of the gate electrode. Another example of an additional step comprises forming a protective layer of a dielectric over the device.

A method of inducing topological behaviour in a semiconductor-ferromagnetic insulator-superconductor hybrid device as described herein will now be discussed with reference to Fig. 5.

At block 501, the semiconductor-ferromagnetic insulator-superconductor hybrid device is cooled to a temperature which is below the critical temperature T_{c} of the superconductor component and the Curie temperature of the ferromagnetic insulator component. By way of illustration, the critical temperature of an aluminium semiconductor component is typically in the region of about 1 K, depending on the thickness of the component. As previously explained, the Curie temperature of the ferromagnetic insulator component is not typically a limiting factor, as this is generally much higher than the critical temperature of the superconductor component.

At block 502, an electrostatic field is applied to the semiconductor-ferromagnetic insulator-superconductor hybrid device. The device may include a gate electrode for applying the electrostatic field.

Under these conditions, in devices having an appropriately-configured ferromagnetic insulator component, interactions between the semiconductor component, the ferromagnetic insulator component and the superconductor component may generate Majorana zero modes.

In examples where a network of nanowires is present, Majorana zero modes may be manipulated, e.g. moved, by varying applied electrostatic fields. A first Majorana zero mode may be moved relative to a second Majorana zero mode, for example. Non-abelian braiding statistics may be observed. Manipulating Majorana zero modes is of particular relevance when the semiconductor-ferromagnetic insulator-superconductor hybrid device is arranged as part of a memory unit for a quantum computer.

It will be appreciated that the above embodiments have been described by way of example only.

More generally, according to one aspect of the invention, there is provided a semiconductor-ferromagnetic insulator-superconductor hybrid device according to claim 1, comprising: a semiconductor component; a ferromagnetic insulating component; and a superconductor component; wherein the semiconductor component has at least three facets; wherein the ferromagnetic insulator component is arranged on a first facet and a second facet; and wherein the superconductor component is arranged on a third facet and extends over the ferromagnetic insulator component on at least the second facet. By arranging the ferromagnetic insulating component and the superconducting component over selected facets of the semiconductor component, a magnetic field may be more effectively applied to a region where the superconductor component and semiconductor component interact. The ferromagnetic insulator component may allow Majorana zero modes to be induced without the need for an externally-applied magnetic field. This may allow for the construction of more elaborate quantum computing device.

The semiconductor component may be in the form of a nanowire. Nanowires may be modelled as "one-dimensional" systems, because the length of a nanowire is many times greater than its diameter. The nanowire may have a diameter in the range 50 to 200 nm, optionally 100 to 150 nm. The nanowire may have a length of at least 1 µm .

In examples where the semiconductor component is in the form of a nanowire, the term "facet" refers to a side-facet of the nanowire. Side facets run along the length of the nanowire. Since a nanowire has a very high aspect ratio, end facets have negligible surface area compared to side facets and need not be considered. In the present context, any interface between the nanowire and any underlying substrate is not regarded as a "facet".

The nanowire may have a hexagonal cross-section. Molecular beam epitaxy is one technique which is useful for manufacturing such nanowires.

Alternatively, the nanowire may be formed integrally with a substrate. Such nanowires may be readily formed by selective area growth, SAG. Such nanowires may have a generally trapezoidal cross-section, for example. A nanowire with a generally trapezoidal cross-section has three available side facets a,b,c on which further components may be arranged.

The material used to form the semiconductor component is not particularly limited. Typically, the semiconductor component comprises a III-V semiconductor.

Examples of useful III-V semiconductor materials include those of general formula:

InAsₓSb₁₋ₓ (Formula 1)

where x is in the range 0 to 1. In other words, the semiconductor component may comprise indium antimonide (x=0), indium arsenide (x=1), or a ternary mixture comprising 50% indium on a molar basis and variable proportions of arsenic and antimony (0 <x <1).

Indium arsenide, InAs, has been found to have good handling properties during manufacture of the device, and provides devices with good performance. Indium antimonide, InSb, may provide further improvements to device performance but may be more difficult to use during manufacturing processes. The ternary mixtures have intermediate properties between those of the binary compounds InAs and InSb. Improvements in device performance compared to InAs may be observed when x is in the range 0 to 0.7, or 0.01 to 0.7. Values of x in the range 0.35 to 0.45 may provide a particularly good balance of device performance and handling properties.

The semiconductor component may comprise indium arsenide. As components of the present devices may be fabricated by epitaxial growth processes, good lattice matching between component materials may be desirable. Indium arsenide has good compatibility with aluminium and europium sulfide in particular.

The ferromagnetic insulator component may comprise a material selected from europium sulfide, europium oxide, and gallium nitride. Examples reported herein used europium sulfide. Europium oxide has similar properties and a similar crystal structure to europium sulfide. Europium oxide has a more rigid lattice than europium sulfide, resulting in a higher Curie temperature.

The ferromagnetic insulator component may have a thickness in the range 1 to 20 nm, optionally 5 to 10 nm. Curie temperature may vary as a function of layer thickness, however in practice this not a limiting parameter. Layer thicknesses within the stated ranges may provide a good balance between magnetic field strength (which increases as the amount of material increases) and ease of fabrication of the device.

The material used to form the superconductor component is not particularly limited, provided that the superconductor component displays superconductive behaviour when the superconductor-semiconductor hybrid device is cooled to an operating temperature. The superconductor component typically comprises an s-wave superconductor. Examples of materials useful as the superconductor component include aluminium, niobium, lead, indium, and tin.

For example, the superconductor component may comprise aluminium, and the superconductor component may have a thickness in the range 3 to 10 nm, optionally 4 to 10 nm. Winkler et al (Physical Review B 99, 245408 (2019)) report that aluminium couples strongly to InAs and InSb, and that the strength of the coupling may vary depending on the thickness of the superconductor layer. This effect may be observed for other semiconductor components according to Formula 1.

The semiconductor-ferromagnetic insulator-superconductor hybrid devices provided herein may further comprise a gate electrode for applying an electrostatic field to the semiconductor component. Electrostatic gating may allow for control over the degree of energy level hybridization between the semiconductor and superconductor. This may be useful for inducing excitations in the device.

The configuration of the gate electrode is not particularly limited provided that the gate electrode is capable of gating the device. One of skill in the art will be familiar with the gating of semiconductor devices. The device may be top-, bottom-, or side-gated.

In a top-gated configuration, the gate electrode is arranged over the superconductor component and/or ferromagnetic insulator component. A layer of a dielectric for preventing flow of current to/from the gate electrode is arranged between the gate electrode and the superconductor component and/or ferromagnetic insulator component. The material which forms the layer of dielectric is not particularly limited, and may be any of the various protective materials known in the field of semiconductor manufacture. Protective layer is typically of an oxide, such as hafnium oxide.

In a side-gated configuration, a gate electrode is arranged to one side or both sides of the device, and is separated from the device by an empty space. The space prevents flow of current between the gate electrode and the other components of the device. A side-gated configuration may optionally further include a layer material of dielectric over the gate electrode and/or device.

In a bottom-gated configuration, the device is arranged on top of a substrate, and the gate electrode is arranged underneath the substrate. In this configuration, the substrate serves to prevent flow of current between the gate electrode and other components.

Optionally, the superconductor component does not extend over the ferromagnetic insulator component on the first facet. It has been found that if the superconductor component extends over both facets which bear the ferromagnetic insulator, then the effects of the ferromagnetic insulator may be diminished.

Typically, the ferromagnetic insulating component is arranged on the first facet and the second facet of the semiconductor component only.

In examples where the semiconductor component has more than three facets, the superconductor component generally does not extend over a fourth facet or any subsequent facet. The superconductor component may be arranged only on a third facet and over the ferromagnetic insulator component on the second facet.

The semiconductor-ferromagnetic-insulator-superconductor hybrid devices provided herein may further comprise a protective insulator component arranged on the ferromagnetic insulator component. The protective insulator component may comprise an aluminium oxide. The protective insulator component may protect the ferromagnetic insulator component during fabrication and/or from the environment. The protective insulator component may decouple, physically and electrically, the superconductor component and ferromagnetic insulator component.

Another aspect of the invention, as defined in claim 9, provides a network of at least two semiconductor-ferromagnetic insulator-superconductor hybrid devices of the invention. A plurality of semiconductor-ferromagnetic insulator-superconductor hybrid devices of the type described herein may be constructed. Devices may be linked by shared semiconductor components. For example, a network of nanowires may be provided, and semiconductor-ferromagnetic insulator-superconductor hybrid devices may be fabricated on the network of nanowires. One example comprises two semiconductor nanowires forming a T-shaped junction, with the two hybrid devices being respectively arranged on the horizontal and vertical parts of the "T".

By providing networks of devices, moving Majorana zero modes relative to one another is made possible. Relative motion produces unusual phenomena, such as non-abelian braiding statistics. Such effects are useful for manipulating and storing information in a quantum computer system.

A still further aspect of the invention, as defined in claim 10, provides a quantum computer device comprising a semiconductor-ferromagnetic insulator-superconductor hybrid device or network of semiconductor-ferromagnetic insulator-superconductor hybrid devices of the invention. Since Majorana zero modes may be induced to in the semiconductor-ferromagnetic insulator-superconductor hybrid devices of the present disclosure, these devices have applications in quantum computing. For example, the semiconductor-ferromagnetic insulator-superconductor hybrid device may be arranged as part of a memory unit of a quantum computer. The devices may be useful for constructing a topological qubit. Usefully, the devices provided herein may be operated without applying an external magnetic field. Structures do not therefore the need to be aligned with a single direction (i.e. the direction of the applied magnetic field) and do not need to be sized to fit into the bore of a high-field magnet, which is typically a few inches in diameter.

Storage of classical information using the ferromagnetic insulator is another possibility. The ferromagnetic insulator component may be used to provide long term, non-volatile memory for superconducting devices.

Also described is the use of a ferromagnetic insulator component of a semiconductor-ferromagnetic insulator-superconductor hybrid device to store data. The device may be a Josephson junction device, in which two superconductor components communicate via a semiconductor component. In a Josephson junction device, the semiconductor component acts as a "weak link" between the two superconductor components, and the two superconductor components may communicate with one another by quantum tunnelling of electrons, e.g. Cooper pairs, through the weak link. The semiconductor-ferromagnetic insulator-superconductor hybrid device may alternatively be configured to be capable of generating Majorana zero modes. The semiconductor-ferromagnetic insulator-superconductor hybrid device may be as defined herein, for example.

Another aspect of the invention provides a method of fabricating a semiconductor-superconductor hybrid device, according to claim 11. The method comprises:
providing a semiconductor component having at least three facets;
directionally depositing, from a first direction, a ferromagnetic insulator component selectively on a first facet and a second facet of the semiconductor component;
forming a superconductor component on at least a third facet of the semiconductor component and over the ferromagnetic insulating component on the second facet.

It should be appreciated that the discussion of the various materials useful for constructing the semiconductor-ferromagnetic insulator-superconductor hybrid device according to the device aspect is also applicable to the method aspect. The method may be adapted to include additional steps for forming any of the additional components described with reference to the device aspect.

Providing the semiconductor component having at least three facets may comprise providing a nanowire of semiconductor material. The nanowire may be grown by molecular beam epitaxy. This may produce a nanowire having a hexagonal cross-section, with six facets. One particular example of molecular beam epitaxy is the vapour-liquid-solid technique.

Alternatively, a nanowire having a generally trapezoidal cross-section may be fabricated on a substrate using selective area growth. In such an example, the first and third facets may be side-facets of the nanowire, and the second facet may be the top facet of the nanowire. The bottom of the generally trapezoidal shape may be an interface with the substrate.

Directionally depositing the ferromagnetic insulator component selectively on the first facet and the second facet may comprise forming the ferromagnetic insulator component by molecular beam epitaxy.

The ferromagnetic insulator component may be deposited from a direction such that the semiconductor component is self-shadowing. Alternatively or additionally, a mask may be used to control the deposition.

Forming the superconductor component may comprise depositing the superconductor component directionally from a second direction, different to the first direction. Forming the superconductor component may comprise forming the superconductor component selectively on a third facet of the semiconductor component and on the ferromagnetic insulating component on the second facet, and not over the first facet. This results in a device having a particularly advantageous structure.

In examples where the semiconductor component has more than three facets, the superconductor component typically is not deposited on or over the fourth or subsequent facets.

The method may further comprise forming a protective insulator layer on the ferromagnetic insulator layer. This may be performed before depositing the superconductor component.

Another aspect of the invention, as defined in claim 14, provides a method of inducing topological behaviour in the semiconductor-ferromagnetic insulator-superconductor hybrid device or network of devices as defined herein, comprising:
cooling the semiconductor-superconductor hybrid device to a temperature at which the superconductor component is superconductive and the ferromagnetic insulator component is below a Curie temperature of the ferromagnetic insulator component; and
applying an electrostatic field to the semiconductor-superconductor hybrid device. The configuration of the superconductor component and ferromagnetic insulator component may allow topological behaviour to be induced without applying an external magnetic field.

The topological behaviour comprises Majorana zero modes, and the method may further comprise inducing motion of the Majorana zero modes. This may be particularly applicable to examples practiced using a network of devices. Moving Majorana zero modes past one another may result in useful phenomena which can be exploited to encode information. In particular, inducing topological behaviour may cause the device to store a quantum bit.

The method may further comprise storing data using the ferromagnetic insulator component. Storing data in this way may modify the superconductive behaviour of the superconductor component.

Other variants or use cases of the disclosed techniques may become apparent to the person skilled in the art once given the disclosure herein, the scope of the invention being solely defined by the claims.

## Claims

1. A semiconductor-ferromagnetic insulator-superconductor hybrid device, comprising:
a semiconductor component (10);
a ferromagnetic insulator component (14); and
a superconductor component (12);
wherein the semiconductor component (10) has at least three facets (1, 2, 3);
wherein the ferromagnetic insulator component (14) is arranged on a first facet (1) and a second facet (2); and
wherein the superconductor component (12) is arranged on a third facet (3) and extends over the ferromagnetic insulator component (14) on at least the second facet (2).

2. The semiconductor-ferromagnetic insulator-superconductor hybrid device according to claim 1, wherein the superconductor component (12) does not extend over the ferromagnetic insulator component (14) on the first facet.

3. The semiconductor-ferromagnetic insulator-superconductor hybrid device according to claim 1 or claim 2, wherein:
the semiconductor component (20) is formed integrally with a substrate (21), and has a generally trapezoidal cross-section; or
wherein the semiconductor component (10) is in the form of a nanowire having a generally hexagonal cross-section.

4. The semiconductor-ferromagnetic insulator-superconductor hybrid device according to any preceding claim, further comprising a protective insulator component (16) arranged on the ferromagnetic insulator component (14), optionally wherein the protective insulator component (16) comprises an aluminium oxide.

5. The semiconductor-ferromagnetic insulator-superconductor hybrid device according to any preceding claim, wherein the semiconductor component (10) comprises a material of Formula 1:
InAsₓSb₁₋ₓ
where x is in the range 0 to 1; optionally wherein the semiconductor component (10) comprises indium arsenide.

6. The semiconductor-ferromagnetic insulator-superconductor hybrid device according to any preceding claim, wherein the ferromagnetic insulator component (14) comprises a material selected from europium sulfide, europium oxide, and gallium nitride.

7. The semiconductor-ferromagnetic insulator-superconductor hybrid device according to any preceding claim, wherein the ferromagnetic insulator component (14) has a thickness in the range 1 to 20 nm.

8. The semiconductor-ferromagnetic insulator-superconductor hybrid device according to any preceding claim, wherein the superconductor component (12) comprises aluminium, and wherein the superconductor component (12) has a thickness in the range 3 to 10 nm.

9. A network (300) of at least two semiconductor-ferromagnetic insulator-superconductor hybrid devices (310, 320) as defined in any preceding claim.

10. A quantum computer device comprising the semiconductor-ferromagnetic insulator-superconductor hybrid device of any of claims 1 to 8, or the network (300) according to claim 9.

11. A method of fabricating a semiconductor-ferromagnetic insulator-superconductor hybrid device, comprising:
providing (401) a semiconductor component (10) having at least three facets (1, 2, 3);
directionally depositing (402), from a first direction, a ferromagnetic insulator component (14) selectively on a first facet (1) and a second facet (2) of the semiconductor component (10);
forming (403) a superconductor component (12) on at least a third facet (3) of the semiconductor component (10) and on the ferromagnetic insulator component (14) over the second facet (2).

12. The method according to claim 11, wherein forming the superconductor component (12) comprises directionally depositing, from a second direction, the superconductor component (12) selectively on the third facet (3) and on the ferromagnetic insulator component (14) over the second facet (2).

13. The method according to claim 11 or claim 12, further comprising, before forming the superconductor component (12), forming a protective insulator component (16) on the ferromagnetic insulator component (14).

14. A method of inducing topological behaviour in the semiconductor-ferromagnetic insulator-superconductor hybrid device as defined in any of claims 1 to 9 or the network according to claim 10, comprising:
cooling (501) the semiconductor-ferromagnetic insulator-superconductor hybrid device to a temperature at which the superconductor component is superconductive and the ferromagnetic insulator component is below a Curie temperature of the ferromagnetic insulator component; and
applying (502) an electrostatic field to the semiconductor-superconductor hybrid device;
wherein the topological behaviour comprises Majorana zero modes.

15. The method according to claim 14, wherein the method further comprises inducing motion of the Majorana zero modes and/or wherein the ferromagnetic insulator component stores data.

## Patentansprüche

1. Halbleiter-ferromagnetische Isolator-Supraleiter-Hybridvorrichtung, umfassend:
eine Halbleiterkomponente (10);
eine ferromagnetische Isolatorkomponente (14); und
eine Supraleiterkomponente (12);
wobei die Halbleiterkomponente (10) mindestens drei Facetten (1, 2, 3) aufweist;
wobei die ferromagnetische Isolatorkomponente (14) auf einer ersten Facette (1) und einer zweiten Facette (2) angeordnet ist; und
wobei die Supraleiterkomponente (12) auf einer dritten Facette (3) angeordnet ist und sich über die ferromagnetische Isolatorkomponente (14) auf mindestens der zweiten Facette (2) erstreckt.

2. Halbleiter-ferromagnetische Isolator-Supraleiter-Hybridvorrichtung nach Anspruch 1, wobei sich die Supraleiterkomponente (12) nicht über die ferromagnetische Isolatorkomponente (14) auf der ersten Facette erstreckt.

3. Halbleiter-ferromagnetische Isolator-Supraleiter-Hybridvorrichtung nach Anspruch 1 oder Anspruch 2, wobei:
die Halbleiterkomponente (20) einstückig mit einem Substrat (21) gebildet ist und einen im Allgemeinen trapezförmigen Querschnitt aufweist; oder
wobei die Halbleiterkomponente (10) in der Form eines Nanodrahts ist, der einen im Allgemeinen hexagonalen Querschnitt aufweist.

4. Halbleiter-ferromagnetische Isolator-Supraleiter-Hybridvorrichtung nach einem vorstehenden Anspruch, weiter umfassend eine schützende Isolatorkomponente (16), die auf der ferromagnetischen Isolatorkomponente (14) angeordnet ist, wobei optional die schützende Isolatorkomponente (16) ein Aluminiumoxid umfasst.

5. Halbleiter-ferromagnetische Isolator-Supraleiter-Hybridvorrichtung nach einem vorstehenden Anspruch, wobei die Halbleiterkomponente (10) ein Material der Formel 1 umfasst: InASₓSb₁₋ₓ
wobei x in dem Bereich von 0 bis 1 ist; wobei wahlweise die Halbleiterkomponente (10) Indiumarsenid umfasst.

6. Halbleiter-ferromagnetische Isolator-Supraleiter-Hybridvorrichtung nach einem vorstehenden Anspruch, wobei die ferromagnetische Isolatorkomponente (14) ein Material umfasst, das ausgewählt ist aus Europiumsulfid, Europiumoxid und Galliumnitrid.

7. Halbleiter-ferromagnetische Isolator-Supraleiter-Hybridvorrichtung nach einem vorstehenden Anspruch, wobei die ferromagnetische Isolatorkomponente (14) eine Dicke in dem Bereich von 1 bis 20 nm aufweist.

8. Halbleiter-ferromagnetische Isolator-Supraleiter-Hybridvorrichtung nach einem vorstehenden Anspruch, wobei die Supraleiterkomponente (12) Aluminium umfasst und wobei die Supraleiterkomponente (12) eine Dicke in dem Bereich von 3 bis 10 nm aufweist.

9. Netzwerk (300) aus mindestens zwei Halbleiter-ferromagnetischen Isolator-Supraleiter-Hybridvorrichtungen (310, 320) wie in einem vorstehenden Anspruch definiert.

10. Quantencomputervorrichtung, umfassend die Halbleiter-ferromagnetische Isolator-Supraleiter-Hybridvorrichtung nach einem der Ansprüche 1 bis 8 oder das Netzwerk (300) nach Anspruch 9.

11. Verfahren zur Fertigung einer Halbleiter-ferromagnetischen Isolator-Supraleiter-Hybridvorrichtung, umfassend:
Bereitstellen (401) einer Halbleiterkomponente (10), die mindestens drei Facetten (1, 2, 3) aufweist;
direktionales Abscheiden (402), aus einer ersten Richtung, einer ferromagnetischen Isolatorkomponente (14) selektiv auf eine erste Facette (1) und eine zweite Facette (2) der Halbleiterkomponente (10);
Bilden (403) einer Supraleiterkomponente (12) auf mindestens einer dritten Facette (3) der Halbleiterkomponente (10) und auf der ferromagnetischen Isolatorkomponente (14) über der zweiten Facette (2).

12. Verfahren nach Anspruch 11, wobei die Supraleiterkomponente (12) direktionales Abscheiden, aus einer zweiten Richtung, der Supraleiterkomponente (12) selektiv auf der dritten Facette (3) und auf der ferromagnetischen Isolatorkomponente (14) über der zweiten Facette (2) umfasst.

13. Verfahren nach Anspruch 11 oder Anspruch 12, weiter umfassend, vor Bilden der Supraleiterkomponente (12), Bilden einer schützenden Isolatorkomponente (16) auf der ferromagnetischen Isolatorkomponente (14).

14. Verfahren zum Induzieren von topologischem Verhalten in der Halbleiter-ferromagnetischen Isolator-Supraleiter-Hybridvorrichtung, wie in einem der Ansprüche 1 bis 9 definiert, oder dem Netzwerk nach Anspruch 10, umfassend:
Kühlen (501) der Halbleiter-ferromagnetischen Isolator-Supraleiter-Hybridvorrichtung auf eine Temperatur, bei der die Supraleiterkomponente supraleitend ist und die ferromagnetische Isolatorkomponente unter einer Curie-Temperatur der ferromagnetischen Isolatorkomponente ist; und
Anlegen (502) eines elektrostatischen Felds an die Halbleiter-Supraleiter-Hybridvorrichtung;
wobei das topologische Verhalten Majorana-Nullmoden umfasst.

15. Verfahren nach Anspruch 14, wobei das Verfahren weiter Induzieren von Bewegung der Majorana-Nullmoden umfasst und/oder wobei die ferromagnetische Isolatorkomponente Daten speichert.

## Revendications

1. Dispositif hybride isolant-supraconducteur semi-conducteur-ferromagnétique, comprenant :
un composant semi-conducteur (10) ;
un composant isolant ferromagnétique (14) ; et
un composant supraconducteur (12) ;
dans lequel le composant semi-conducteur (10) présente au moins trois facettes (1, 2, 3) ;
dans lequel le composant isolant ferromagnétique (14) est agencé sur une première facette (1) et une deuxième facette (2) ; et
dans lequel le composant supraconducteur (12) est agencé sur une troisième facette (3) et s'étend par-dessus le composant isolant ferromagnétique (14) sur au moins la deuxième facette (2).

2. Dispositif hybride isolant-supraconducteur semi-conducteur-ferromagnétique selon la revendication 1, dans lequel le composant supraconducteur (12) ne s'étend pas par-dessus le composant isolant ferromagnétique (14) sur la première facette.

3. Dispositif hybride isolant-supraconducteur semi-conducteur-ferromagnétique selon la revendication 1 ou la revendication 2, dans lequel :
le composant semi-conducteur (20) est formé d'un seul bloc avec un substrat (21) et présente une coupe transversale généralement trapézoïdale ; ou
dans lequel le composant semi-conducteur (10) est sous la forme d'un nanofil présentant une coupe transversale généralement hexagonale.

4. Dispositif hybride isolant-supraconducteur semi-conducteur-ferromagnétique selon une quelconque revendication précédente, comprenant en outre un composant isolant protecteur (16) agencé sur le composant isolant ferromagnétique (14), facultativement dans lequel le composant isolant protecteur (16) comprend un oxyde d'aluminium.

5. Dispositif hybride isolant-supraconducteur semi-conducteur-ferromagnétique selon une quelconque revendication précédente, dans lequel le composant semi-conducteur (10) comprend un matériau selon la Formule 1 : InAsₓSb₁₋ₓ
dans lequel x est dans la plage de 0 à 1 ; facultativement dans lequel le composant semi-conducteur (10) comprend de l'arséniure d'indium.

6. Dispositif hybride isolant-supraconducteur semi-conducteur-ferromagnétique selon une quelconque revendication précédente, dans lequel le composant isolant ferromagnétique (14) comprend un matériau sélectionné parmi le sulfure d'europium, l'oxyde d'europium et le nitrure de gallium.

7. Dispositif hybride isolant-supraconducteur semi-conducteur-ferromagnétique selon une quelconque revendication précédente, dans lequel le composant isolant ferromagnétique (14) présente une épaisseur dans la plage de 1 à 20 nm.

8. Dispositif hybride isolant-supraconducteur semi-conducteur-ferromagnétique selon une quelconque revendication précédente, dans lequel le composant supraconducteur (12) comprend de l'aluminium et dans lequel le composant supraconducteur (12) présente une épaisseur dans la plage de 3 à 10 nm.

9. Réseau (300) d'au moins deux dispositifs hybrides isolants-supraconducteurs semiconducteurs-ferromagnétiques (310, 320) tels que définis dans une quelconque revendication précédente.

10. Dispositif informatique quantique comprenant le dispositif hybride isolant-supraconducteur semi-conducteur-ferromagnétique selon l'une quelconque des revendications 1 à 8, ou le réseau (300) selon la revendication 9.

11. Procédé de fabrication d'un dispositif hybride isolant-supraconducteur semi-conducteur-ferromagnétique, comprenant :
la fourniture (401) d'un composant semi-conducteur (10) présentant au moins trois facettes (1, 2, 3) ;
le dépôt directionnel (402), à partir d'une première direction, d'un composant isolant ferromagnétique (14) de manière sélective sur une première facette (1) et une deuxième facette (2) du composant semi-conducteur (10) ;
la formation (403) d'un composant supraconducteur (12) sur au moins une troisième facette (3) du composant semi-conducteur (10) et sur le composant isolant ferromagnétique (14) par-dessus la deuxième facette (2).

12. Procédé selon la revendication 11, dans lequel la formation du composant supraconducteur (12) comprend le dépôt directionnel, à partir d'une seconde direction, du composant supraconducteur (12) de manière sélective sur la troisième facette (3) et sur le composant isolant ferromagnétique (14) par-dessus la deuxième facette (2).

13. Procédé selon la revendication 11 ou la revendication 12, comprenant en outre, avant la formation du composant supraconducteur (12), la formation d'un composant isolant protecteur (16) sur le composant isolant ferromagnétique (14).

14. Procédé d'induction d'un comportement topologique dans le dispositif hybride isolant-supraconducteur semi-conducteur-ferromagnétique tel que défini dans l'une quelconque des revendications 1 à 9 ou le réseau selon la revendication 10, comprenant :
le refroidissement (501) du dispositif hybride isolant-supraconducteur semi-conducteur-ferromagnétique jusqu'à une température à laquelle le composant supraconducteur est supraconducteur et le composant isolant ferromagnétique est en dessous d'une température de Curie du composant isolant ferromagnétique ; et
l'application (502) d'un champ électrostatique sur le dispositif hybride semi-conducteur-supraconducteur ;
dans lequel le comportement topologique comprend des modes zéro de Majorana.

15. Procédé selon la revendication 14, dans lequel le procédé comprend en outre l'induction d'un mouvement des modes zéro de Majorana et/ou dans lequel le composant isolant ferromagnétique stocke des données.
